# EUROPÄISCHE PATENTANMELDUNG

(11) **EP 0 766 288 A2**
(43) Veröffentlichungstag der Anmeldung: **02.04.1997**
(21) Anmeldenummer: 96114616.4
(22) Anmeldetag: 11.09.1996
(51) Int. Cl.: H01L 21/00

(54) **Vorrichtung und Verfahren zur Prozessierung von Halbleiterelementen**

(30) Priorität: 28.09.1995 DE 19536215
(71) Anmelder: SIEMENS AKTIENGESELLSCHAFT, 80333 München (DE)
(72) Erfinder: Schwendner, Hans, Dipl.-Ing., 83026 Rosenheim (DE)

(57) **Zusammenfassung**

Die Erfindung schlägt eine Vorrichtung und ein Verfahren vor zur Prozessierung von Halbleiterelementen mit einer ersten Einrichtung (1), die Schall (AP1) mit einer ersten Phase und einer ersten Amplitude erzeugt, und mit einer zweiten Einrichtung (2, 3), die Schall (AP2) mit einer zweiten Phase erzeugt, die der ersten Phase entgegengerichtet ist. Die Schallamplitude der zweiten Einrichtung entspricht vorzugsweise der Amplitude der ersten Einrichtung. Damit ist eine wirksame Entkopplung der ersten Einrichtung von einer Prozeßkammer (P) möglich. Beide Einrichtungen können in einer schallgedämpften Kammer (4) angeordnet sein. Dadurch ist eine aufwendige mechanische Schall- und Vibrationsdämpfung nicht mehr erforderlich.

## Beschreibung

Die Erfindung betrifft eine Vorrichtung und ein Verfahren zur Prozessierung von Halbleiterelementen mit einer ersten Einrichtung, die Schall mit einer ersten Phase und einer ersten Amplitude erzeugt.

Die Herstellung von Halbleiterchips erfordert neben der Entwicklung entsprechender Schaltungen und Technologien auch dementsprechend entwickelte Vorrichtungen, mit denen die Technologien umgesetzt, d.h. Chips hergestellt werden können. So sind beispielsweise Prozeßkammern erforderlich, in denen Halbleiterscheiben bearbeitet werden können. Die Prozeßkammern wiederum sind an Einrichtungen angeschlossen, mit denen die Halbleiterscheiben auf einem Arbeitstisch fixiert und beschichtet, belichtet und geätzt werden können. Dies erfolgt unter den atmosphärischen Bedingungen des jeweiligen Prozeßschrittes.

In jedem Fall müssen zur Erzeugung und Einhaltung der Prozeßvorschriften Vorrichtungen in Form von Motoren und (Vakuum-) Pumpen betrieben werden, die ihrerseits den Herstellungsprozeß nicht beeinträchtigen dürfen. Mit abnehmenden Strukturabmessungen ist dabei diese Bedingung nur schwer erfüllbar, weil mechanisch arbeitende Einrichtungen immer vibrieren und Geräusche erzeugen, d.h. im weitesten Sinn Schall aussenden, der wiederum die Prozessierung der Scheiben beeinflußt und die Ausschußquote steigen läßt. Derartige Vorrichtungen müssen deshalb möglichst von der eigentlichen Prozessierung bzw. Fertigung der Halbleiter entkoppelt sein.

Schall erzeugende Einrichtungen in der Halbleitertechnik wie z. B. Motoren oder Vakuumpumpen werden aus den genannten Gründen sehr aufwendig montiert, um weitgehende Erschütterungsfreiheit zu erhalten und die Vibrationen und die Geräuschentwicklung nicht auf die eigentliche Fertigungseinrichtung zu übertragen. Üblich ist die Montage der Motoren und Pumpen auf schweren Stahlgerüsten, was aufwendig und teuer ist.

Der Erfindung liegt die Aufgabe zugrunde, die bisherige Technik zu verbessern.

Diese Aufgabe löst die Erfindung mit den Merkmalen der Ansprüche 1, 8 und 13.

Die Erfindung hat den Vorteil, daß aufwendige mechanische Maßnahmen zur Schalldämpfung und Entkopplung der Schallquellen nicht mehr erforderlich sind.

Ausgestaltungen der Erfindung sind in Unteransprüchen gekennzeichnet.

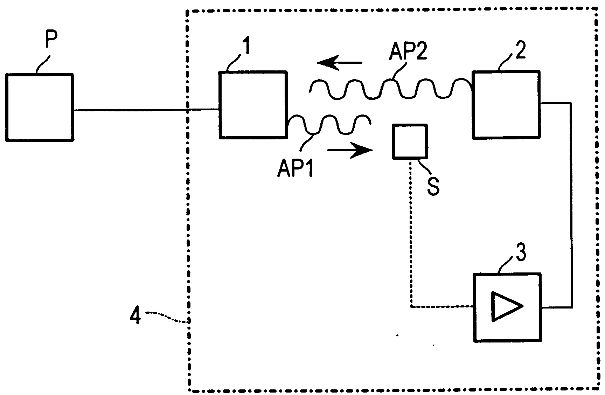

Die Erfindung wird nachfolgend anhand der Figur der Zeichnung näher erläutert.

Gemäß der Figur umfaßt die Vorrichtung zur Prozessierung von Halbleiterbauelementen eine Prozeßkammer P und Einrichtungen 1 bis 4, die mit der Prozeßkammer über eine Verbindungseinrichtung V in Verbindung stehen. Unter Prozeßkammer P wird dabei eine Einheit verstanden, die für irgendeinen Prozeßschritt bei der Herstellung eines integrierten Schaltkreises vom Wafer bis zum fertigen Bauelement Verwendung findet.

Die Prozeßkammer 1 ist über die Verbindungseinrichtung V an einer ersten Einrichtung 1 angeschlossen, die Schall AP1 mit einer ersten Phase und mit einer ersten Amplitude erzeugt. Diese erste Einrichtung kann ein Motor, eine Pumpe, ein Ventilator, ein Ventil oder jede andere Einrichtung sein, die in irgendeiner Form Schall, z.B. durch Vibration aussendet. Die Verbindungseinrichtung V umfaßt jede Form einer Verbindung zwischen der ersten Einrichtung 1 und der Prozeßkammer P, über die sich neben der gewünschten Verbindungsfunktion der Schall AP1 der ersten Einrichtung 1 auf die Prozeßkammer P auswirken kann.

Zur schalltechnischen Entkopplung der Prozeßkammer P von der ersten Einrichtung 1 ist eine zweite Einrichtung 2,3 vorgesehen, die Schall AP2 mit einer zweiten Phase aussendet, der der ersten Phase entgegengerichtet ist, d.h. eine Phasenverschiebung von idealerweise 180° gegenüber der Phase von AP1 besitzt. Dieser Idealfall muß jedoch nicht notwendig erfüllt sein, sondern es genügt abhängig von den Gegebenheiten des Gesamtsystems eine Phasenverschiebung mit einer Bandbreite um 180°. Diese Gegebenheiten können in der relativen Unempfindlichkeit des jeweiligen Prozessierungsschrittes gegenüber Schalleinflüssen oder in zusätzlichen Dämpfungsmaßnahmen liegen, die verbleibenden Restschall nach der Antischallbestrahlung mit der zweiten Einrichtung 2,3 weiter reduzieren. Die Bandbreite der Phasenverschiebung des gegengerichteten Schalls AP2 gegenüber dem Schall AP1 sollte deshalb höchstens plus/minus 80° betragen und zwischen 100° und 260°, vorzugsweise jedoch möglichst nahe bei 180° liegen.

In entsprechender Weise sollte die Schallamplitude der zweiten Einrichtung 2,3 vorzugsweise gleich der ersten Amplitude der ersten Einrichtung 1 sein, um eine möglichst optimale Kompensation des Schalls der ersten Einrichtung 1 zu erhalten. Eine Bandbreite der Schallamplitude der zweiten Einrichtung ist zulässig und hängt wesentlich von den äußeren Gegebenheiten wie z.B. zusätzlichen Dämpfungsmaßnahmen ab.

Die zweite Einrichtung 2,3 enthält einen Verstärker 3, der einen Schallerzeuger 2, beispielsweise einen Lautsprecher oder ein Lautsprechersystem steuert. Abhängig von der Art des zu kompensierenden Schalls AP1 der ersten Einrichtung wird der Schallerzeuger 2 hinsichtlich seines Schallspektrums gut darauf abgestimmt. Dies ist leicht möglich, da die erste Einrichtung 1 üblicherweise konstanten Schall oder gleich ablaufende Schallmuster erzeugt. Beispielsweise läuft ein Motor oder eine Pumpe mit konstanter Drehzahl oder besitzt gleichablaufende Anlauf- oder Auslaufvorgänge.

Darüber hinaus kann eine Regelung vorgesehen werden, indem über mindestens einen Sensor der Schall der ersten Einrichtung erfaßt und das Ausgangssignal des Sensors dem Verstärker 3 zugeführt wird. Ein Sensor dieser Art kann ein Mikrophon oder ein anderer Schallsensor sein. In der Figur der Zeichnung ist eine Sensoreinrichtung S gestrichelt als Alternative gezeichnet.

Weiterhin ist vorgesehen, daß die erste und die zweite Einrichtung - und gegebenenfalls die Sensoreinrichtung S - in einer schalldämmenden Kammer 4 oder Kapsel angeordnet sind. Dies hat den Vorteil, daß bei nicht genau gegenphasigem Schall der zweiten Einrichtung der verbleibende Rest des Schalls der ersten Einrichtung gedämpft werden kann. Die schalldämpfende Kammer kann mit einfachen Mitteln ohne große konstruktive Maßnahmen wie bisher üblich realisiert sein. Die Anordnung der ersten und der zweiten Einrichtung in der schallgedämmten Kammer ist unkritisch.

Mit der Erfindung ist somit eine einfache und kostengünstige Möglichkeit geschaffen, schallabstrahlende Einrichtungen für die Prozessierung von Halbleiterbauelementen von der jeweiligen Prozeßkammer zu entkoppeln, ohne daß aufwendige konstruktive Maßnahmen für die Schall- bzw. Vibrationsdämpfung vorgesehen sein müssen.

## Patentansprüche

1. Vorrichtung zur Prozessierung von Halbleiterbauelementen mit einer ersten Einrichtung (1), die Schall (AP1) mit einer ersten Phase und einer ersten Amplitude erzeugt, und mit einer zweiten Einrichtung (2, 3), die Schall (AP2) mit einer zweiten Phase erzeugt, die der ersten Phase entgegengerichtet ist.

2. Vorrichtung nach Anspruch 1, dadurch gekennzeichnet, daß die Schallamplitude der zweiten Einrichtung (2, 3) auf die erste Amplitude abgestimmt ist.

3. Vorrichtung nach Anspruch 1 oder 2, dadurch gekennzeichnet, daß die erste Einrichtung (1) einen Motor und/oder eine Pumpe und daß die zweite Einrichtung (2, 3) einen Lautsprecher enthält.

4. Vorrichtung nach einem der Ansprüche 1 bis 3, dadurch gekennzeichnet, daß die erste und die zweite Einrichtung gemeinsam in einer Kammer (4) angeordnet sind.

5. Vorrichtung nach Anspruch 4, dadurch gekennzeichnet, daß die Kammer schallgedämpft ist.

6. Vorrichtung nach einem der vorhergehenden Ansprüche, dadurch gekennzeichnet, daß die zweite Einrichtung mittels mindestens eines Sensors (S) geregelt ist, so daß die zweite Phase abhängig von der ersten Phase erzeugt wird.

7. Vorrichtung nach Anspruch 6, dadurch gekennzeichnet, daß die Schallamplitude der zweiten Einrichtung abhängig von der ersten Amplitude geregelt wird.

8. Verfahren zur Prozessierung von Halbleiterbauelementen, bei dem eine erste Einrichtung (1) Schall (AP1) mit einer ersten Phase und einer ersten Amplitude erzeugt, und bei dem eine zweite Einrichtung (2, 3) Schall (AP2) mit einer zweiten Phase erzeugt, die der ersten Phase entgegengerichtet ist.

9. Verfahren nach Anspruch 8, dadurch gekennzeichnet, daß die Schallamplitude der zweiten Einrichtung (2, 3) auf die erste Amplitude abgestimmt wird.

10. Verfahren nach Anspruch 8 oder 9, dadurch gekennzeichnet, daß die erste und die zweite Einrichtung gemeinsam in einer schalldämpfenden Kammer (4) betrieben werden.

11. Verfahren nach einem der Ansprüche 8 bis 10, dadurch gekennzeichnet, daß die zweite Einrichtung mittels mindestens eines Sensors (S) geregelt wird, so daß die zweite Phase abhängig von der ersten Phase erzeugt wird.

12. Verfahren nach Anspruch 11, dadurch gekennzeichnet, daß die Schallamplitude der zweiten Einrichtung abhängig von der ersten Amplitude geregelt wird.

13. Verwendung einer Vorrichtung mit einer ersten Einrichtung (1), die Schall (AP1) mit einer ersten Phase und einer ersten Amplitude erzeugt, und mit einer zweiten Einrichtung (2, 3), die Schall (AP2) mit einer zweiten Phase erzeugt, die der ersten Phase entgegengerichtet ist, zur Prozessierung von Halbleiterbauelementen.
